# EUROPÄISCHE PATENTSCHRIFT

(11) **EP 2 972 548 B1**
(45) Veröffentlichungstag und Bekanntmachung des Hinweises auf die Patenterteilung: **18.09.2019**
(21) Anmeldenummer: 14710865.8
(22) Anmeldetag: 14.03.2014
(51) Int. Cl.: G02B 19/00, G02B 27/09, H01S 5/40, G02B 3/00

(54) **LASERDIODENBARRENBELEUCHTUNGSVORRICHTUNG**
LIGHTENING DEVICE FOR LASER DIODE BARS
DISPOSITIF D'ECLAIRAGE POUR UNE BARRETTE DE DIODES LASER

(30) Priorität: 14.03.2013 DE 102013102599
(43) Veröffentlichungstag der Anmeldung: 20.01.2016
(73) Patentinhaber: LIMO GmbH, 44319 Dortmund (DE)
(72) Erfinder: MITRA, Thomas, 44309 Dortmund (DE)
(74) Vertreter: Manske, Jörg
(86) Internationale Anmeldenummer: PCT/EP2014/055115
(87) Internationale Veröffentlichungsnummer: WO 2014/140285

(56) Entgegenhaltungen:
- DE-A1- 10 209 605
- US-A- 6 044 096
- US-A- 6 166 759
- US-A1- 2005 063 435
- US-A1- 2006 159 147
- US-A1- 2006 291 509
- PETER SCHREIBER ; BERND HOEFER ; PETER DANNBERG ; UWE D. ZEITNER: "High-brightness fiber-coupling schemes for diode laser bars", PROC. SPIE 5876, LASER BEAM SHAPING VI, 31. Juli 2005 (2005-07-31), Seiten 587602-1-587602-9, XP040207797,

## Beschreibung

Die vorliegende Erfindung betrifft eine Beleuchtungsvorrichtung nach dem Oberbegriff des Anspruchs 1. Darüber hinaus betrifft die vorliegende Erfindung eine Beleuchtungsvorrichtung nach dem Oberbegriff des Anspruchs 4.

Definitionen: Unter "Ausbreitungsrichtung" wird die mittlere Ausbreitungsrichtung des Lichts verstanden, insbesondere wenn dieses keine ebene Welle ist oder zumindest teilweise konvergent oder divergent ist. Mit Lichtstrahl, Teilstrahl oder Strahl ist, wenn nicht ausdrücklich etwas anderes angegeben ist, kein idealisierter Strahl der geometrischen Optik gemeint, sondern ein realer Lichtstrahl, wie beispielsweise ein Laserstrahl mit einem Gauß-Profil, der keinen infinitesimal kleinen, sondern einen ausgedehnten Strahlquerschnitt aufweist.

Laserdiodenbarren sind als Laserlichtquellen aus dem Stand der Technik bekannt und weisen eine Mehrzahl von Halbleiter-Emittern auf, die in einer ersten Richtung - der so genannten Slow-Axis-Richtung (lange Achse) - mit Abstand zueinander nebeneinander angeordnet sind. Die Slow-Axis-Richtung ist diejenige Richtung, in der sich die aktive Schicht der Halbleiterdiode erstreckt, wohingegen die so genannte Fast-Axis-Richtung (kurze Achse) die dazu senkrechte Richtung ist. Die von den einzelnen Emittern des Laserdiodenbarrens emittierten Teilstrahlen weisen in der Fast-Axis-Richtung eine wesentlich größere Divergenz auf als in der Slow-Axis-Richtung. Dies hat zur Folge, dass sich die Teilstrahlen auf der kurzen Achse schneller verbreitern als auf der langen Achse.

Im Stand der Technik werden insbesondere fasergekoppelte Beleuchtungsvorrichtungen mit mindestens einem Laserdiodenbarren so aufgebaut, dass das Strahlparameterprodukt dieses Laserdiodenbarrens mit einem optischen Strahltransformationsmittel, wie es beispielsweise in der EP 1 006 382 A1 offenbart ist, symmetrisiert wird. Ein derartiges optisches Strahltransformationsmittel weist eine Lichteintrittsseite, durch die das Laserlicht eintreten kann, mit einer Anzahl parallel zueinander angeordneter Zylinderlinsensegmente und eine Lichtaustrittsseite mit einer Anzahl parallel zueinander angeordneter Zylinderlinsensegmente auf. Die Achsen der Zylinderlinsensegmente auf der Lichteintrittsseite und auf der Lichtaustrittsseite schließen mit einer Basisseite des Strahltransformationsmittels, die sich in der ersten Richtung (x-Richtung) erstreckt, einen Winkel von 45° ein. Beim Durchgang eines linienförmig auf das Strahltransformationsmittel auftreffenden Laserstrahls, wie er von dem Laserdiodenbarren erzeugt werden kann, erfahren die Teilstrahlen beim Durchgang durch das Strahltransformationsmittel eine gemeinsame Strahldrehung um 90°.

Aus geometrischen Gründen muss zwischen den einzelnen Teilstrahlen, die aus dem Strahltransformationsmittel heraustreten, ein relativ großer Abstand eingehalten werden. Dieser notwendige Abstand verschlechtert das Strahlparameterprodukt, welches eine physikalische Kenngröße ist, mit der sich die Strahlqualität und somit auch die Fokussierbarkeit eines Laserstrahls beschreiben lässt, in der langen Achse hinter dem Strahltransformationsmittel gegenüber dem theoretisch möglichen Wert erheblich. Ein möglicher Ansatz, um das Strahlparameterprodukt zu verbessern, besteht zum Beispiel darin, hinter dem Strahltransformationsmittel ein Strahlaufweitungsmittel, insbesondere ein Teleskoparray mit einer Mehrzahl von Teleskopmitteln, anzuordnen. Dadurch kann zumindest theoretisch erreicht werden, dass die Divergenz der einzelnen Teilstrahlen reduziert wird. Ferner können die einzelnen Strahlbreiten vergrößert werden und die theoretisch unnötigen Lücken zwischen benachbarten Teilstrahlen können geschlossen werden. In der praktischen Anwendung scheitert ein derartiger Ansatz jedoch an der so genannten "Smile"-Verzerrung der Emitter des Laserdiodenbarrens. Ursache dieser "Smile"-Verzerrung ist eine fertigungsbedingte Durchbiegung des Laserdiodenbarrens, die dazu führt, dass sich die Teilstrahlen hinter dem Strahltransformationsmittel nicht parallel zueinander ausbreiten. Im realen Aufbau der Beleuchtungsvorrichtung mit einem Fast-Axis-Kollimationsmittel und einem Strahltransformationsmittel wirkt sich die "Smile"-Verzerrung in der Weise aus, dass einige der Emitter des Laserdiodenbarrens nicht auf der Höhe der optischen Achse abstrahlen. Die optische Achse für jeden der Emitter wird dabei durch den Scheitel des vorzugsweise als Zylinderlinsenmittel ausgeführten Fast-Axis-Kollimationsmittels definiert. Die Teilstrahlen derjenigen Emitter des Laserdiodenbarrens, die das Fast-Axis-Kollimationsmittel in der "falschen" Höhe treffen, werden zwar gut kollimiert, das Poynting der kollimierten Teilstrahlen dieser Emitter hat aber einen Fehler gegenüber den übrigen, in der "richtigen" Höhe liegenden Emittern. Dieser Poynting-Fehler lässt sich wie folgt abschätzen: Höhenfehler [µm] / Brennweite des Fast-Axis-Kollimationsmittels [mm] = Poynting-Fehler [mrad].

Nach der Drehung der Teilstrahlen durch das Strahltransformationsmittel ist der Poynting-Fehler ebenfalls gedreht. Daraus folgt, dass die Einhüllende der Winkelverteilung aller Emitter des Laserdiodenbarrens entsprechend vergrößert (verbreitert) ist.

Aus der US 2005/0063435 A1 ist eine Beleuchtungsvorrichtung der eingangs genannten Art mit einem Laserdiodenbarren-Stack bekannt, der eine Mehrzahl übereinander gestapelter Laserdiodenbarren aufweist. In Strahlausbreitungsrichtung sind hinter dem Strahltransformationsmittel mehrere Prismenmittel übereinander angeordnet. Den Emittern jedes der Laserdiodenbarren ist jeweils ein gemeinsames Prismenmittel zugeordnet. Diese Beleuchtungsvorrichtung befasst sich nicht mit der Kompensation der "Smile" Verzerrung, deren Ursache die fertigungsbedingte Durchbiegung der Laserdiodenbarren und der daraus resultierende Höhenversatz einzelner Emitter im Vergleich zu anderen Emittern desselben Laserdiodenbarrens ist.

Aus der US 2006/159147 A1 ist eine Beleuchtungsvorrichtung bekannt, bei der eine Kompensation der "Smile" Verzerrung eines Laserdiodenbarrens mit Hilfe symmetrischer und asymmetrischer Zylinderlinsensegmente im Strahltransformationsmittel erfolgt.

Der vorliegenden Erfindung liegt die Aufgabe zu Grunde, eine Beleuchtungsvorrichtung zur Verfügung zu stellen, die eine wirksame Kompensation der "Smile"-Verzerrung ermöglicht, um dadurch das Strahlparameterprodukt möglichst nahe an die theoretisch mögliche Grenze zu bringen.

Die Lösung dieser Aufgabe liefert eine Beleuchtungsvorrichtung mit den Merkmalen des kennzeichnenden Teils des Anspruchs 1. Eine alternative Lösung dieser Aufgabe liefert eine Beleuchtungsvorrichtung mit den Merkmalen des kennzeichnenden Teils des Anspruchs 4. Die Unteransprüche betreffen vorteilhafte Weiterbildungen der Erfindung.

Eine erfindungsgemäße Beleuchtungsvorrichtung zeichnet sich gemäß Anspruch 1 dadurch aus, dass die Beleuchtungsvorrichtung ein Prismenarray umfasst, das in Strahlausbreitungsrichtung hinter dem Strahltransformationsmittel angeordnet ist und eine der Anzahl der Emitter entsprechende Anzahl von Prismenmitteln umfasst, die in der ersten Richtung nebeneinander angeordnet sind und jeweils eine Lichteintrittsfläche und eine Lichtaustrittsfläche für einen der Teilstrahlen aufweisen, wobei die Lichteintrittsflächen und/oder die Lichtaustrittsflächen derjenigen Prismenmittel, durch die diejenigen Teilstrahlen hindurchtreten, die vor der Strahldrehung mittels des Strahltransformationsmittels einen Höhenversatz aufweisen, so ausgebildet sind, dass ein Poynting-Fehler [mrad] = Höhenfehler [µm] / Brennweite [mm] des Fast-Axis-Kollimationsmittels durch Parallelisieren dieser Teilstrahlen korrigiert wird, wobei die Lichtaustrittsflächen derjenigen Prismenmittel, durch die diejenigen Teilstrahlen hindurchtreten, die vor der Strahldrehung mittels des Strahltransformationsmittels einen Höhenversatz aufweisen, in der ersten Richtung keilförmig ausgebildet sind, und wobei diejenigen Prismenmittel, durch die diejenigen Teilstrahlen hindurchtreten, die vor der Strahldrehung mittels des Strahltransformationsmittel keinen Höhenversatz aufweisen, zueinander parallele Lichteintrittsflächen und Lichtaustrittsflächen aufweisen. Das Prismenarray ist mit anderen Worten so gestaltet, dass der Poynting-Fehler in Strahlausbreitungsrichtung hinter dem Strahltransformationsmittel für jeden Emitter durch ein in geeigneter Weise geformtes Prismenmittel korrigiert werden kann. Somit wird eine wirksame Kompensation der "Smile"-Verzerrung erreicht, so dass das Strahlparameterprodukt möglichst nahe an die theoretisch mögliche Grenze gebracht werden kann.

Eine besonders effiziente Kompensation der "Smile"-Verzerrung kann erfindungsgemäß dadurch erreicht werden, dass die Lichtaustrittsflächen derjenigen Prismenmittel, durch die diejenigen Teilstrahlen hindurchtreten, die vor der Strahldrehung mittels des Strahltransformationsmittels einen Höhenversatz aufweisen, in der ersten Richtung keilförmig ausgebildet sind. Die Lichteintrittsflächen dieser Prismenmittel sind vorzugsweise plan ausgeführt.

Um nach der mittels des Prismenarrays erfolgten Kompensation der "Smile"-Verzerrung die Lücken zwischen den kollimierten Teilstrahlen zu füllen und die Divergenz wirksam zu reduzieren, wird in einer besonders vorteilhaften Ausführungsform vorgeschlagen, dass in Strahlausbreitungsrichtung hinter dem Prismenarray mindestens ein Strahlaufweitungsmittel angeordnet ist. Das Strahlaufweitungsmittel kann in einer besonders vorteilhaften Ausführungsform ein Teleskoparray mit einer Mehrzahl von Teleskopmitteln umfassen, die in der ersten Richtung nebeneinander angeordnet sind. Dabei ist vorzugsweise jedem der Emitter beziehungsweise jedem der Teilstrahlen genau ein Teleskopmittel zugeordnet.

Gemäß Anspruch 4 sieht eine alternative Lösung der Aufgabe der vorliegenden Erfindung vor, dass die Lichteintrittsflächen und/oder die Lichtaustrittsflächen derjenigen Teleskopmittel, durch die diejenigen Teilstrahlen hindurchtreten, die vor der Strahldrehung mittels des Strahltransformationsmittels einen Höhenversatz aufweisen, so ausgebildet sind, dass ein Poynting-Fehler [mrad] = Höhenfehler [µm] / Brennweite [mm] des Fast-Axis-Kollimationsmittels durch Parallelisieren dieser Teilstrahlen korrigiert wird. Im Gegensatz zu der in Anspruch 1 beschriebenen Lösung weist die Beleuchtungsvorrichtung ein Teleskop-Array zur Aufweitung der Teilstrahlen und zur Verringerung der Strahldivergenz auf, wobei einige der Teleskopmittel speziell geformt sind, um den Poynting-Fehler zu kompensieren. Dadurch wird ebenfalls eine wirksame Kompensation der "Smile"-Verzerrung erreicht, so dass das Strahlparameterprodukt möglichst nahe an die theoretisch mögliche Grenze gebracht werden kann.

In einer bevorzugten Ausführungsform kann vorgesehen sein, dass die Lichteintrittsflächen und/oder die Lichtaustrittsflächen derjenigen Teleskopmittel, durch die diejenigen Teilstrahlen, die vor der Strahldrehung mittels des Strahltransformationsmittels einen Höhenversatz aufweisen, hindurchtreten, asymmetrisch in Bezug auf die optische Achse der ihnen zugeordneten Teilstrahlen geformt sind/ist.

In einer alternativen bevorzugten Ausführungsform besteht auch die Möglichkeit, dass diejenigen Teleskopmittel, durch die diejenigen Teilstrahlen, die vor der Strahldrehung mittels des Strahltransformationsmittels einen Höhenversatz aufweisen, hindurchtreten, einen seitlichen Versatz zur optischen Achse aufweisen.

In einer besonders vorteilhaften Ausführungsform wird vorgeschlagen, dass die Lichteintrittsflächen der Teleskopmittel konkav geformt sind und dass die Lichtaustrittsflächen der Teleskopmittel konvex geformt sind. Dadurch kann eine effiziente Aufweitung der Teilstrahlen erreicht werden.

Die Grundidee der vorliegenden Erfindung zielt auf eine Verringerung der Strahldivergenz der von den Emittern mindestens eines Laserdiodenbarrens emittierten Laserstrahlung ab, die zum Beispiel für eine Faserkopplung vorgesehen sein kann. Die erfindungsgemäßen Beleuchtungsvorrichtungen sind dazu in der Lage, die Poynting-Fehler einzelner Emitter wieder zu korrigieren, so dass die Einhüllende der Winkelverteilungen der Winkelverteilung eines Emitters entspricht.

Nach der Kompensation der "Smile"-Verzerrung kann eine Zylinderlinse in allen hier vorgestellten Ausführungsformen der Beleuchtungsvorrichtung die Divergenz der Slow-Axis kollimieren. Der auf diese Weise kollimierte und symmetrisierte Laserstrahl kann mit zwei Zylinderlinsen oder einer sphärisch oder asphärisch ausgebildeten Linse in eine optische Faser eingekoppelt werden.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen
- Fig. 1: eine schematisch stark vereinfachte Seitenansicht einer Beleuchtungsvorrichtung, die gemäß einem ersten Ausführungsbeispiel der vorliegenden Erfindung ausgeführt ist,
- Fig. 2: eine schematisch stark vereinfachte Seitenansicht einer Beleuchtungsvorrichtung, die gemäß einem zweiten Ausführungsbeispiel der vorliegenden Erfindung ausgeführt ist,
- Fig. 3: eine schematisch stark vereinfachte Seitenansicht einer Beleuchtungsvorrichtung, die nicht Gegenstand der Erfindung ist,

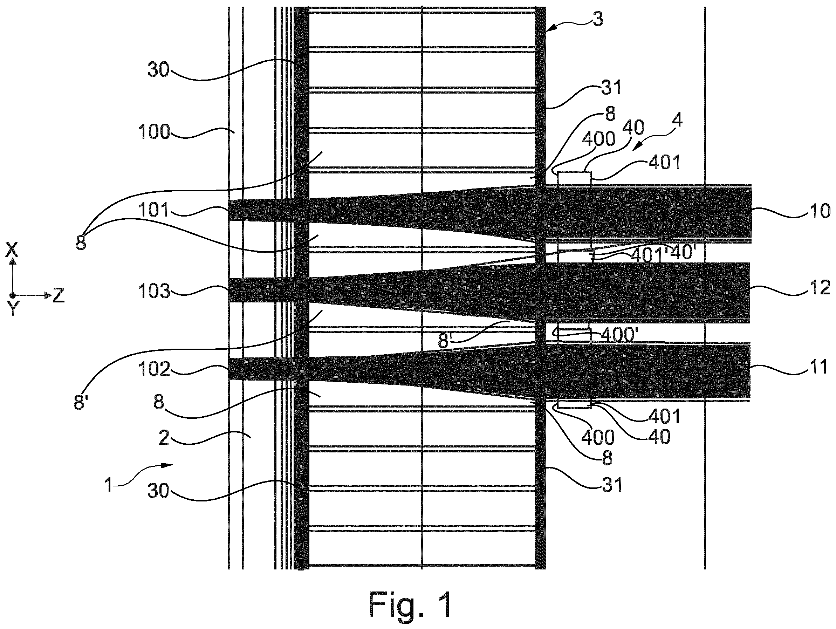

Unter Bezugnahme auf Fig. 1 soll nachfolgend ein erstes Ausführungsbeispiel einer Beleuchtungsvorrichtung 1 näher erläutert werden. Zur Vereinfachung der weiteren Beschreibung wurde in Fig. 1 ein kartesisches Koordinatensystem eingefügt, wobei die z-Richtung die Ausbreitungsrichtung des Laserlichts ist.

Die Beleuchtungsvorrichtung 1 umfasst eine Laserlichtquelle, die einen Laserdiodenbarren 100 umfasst. Der Laserdiodenbarren 100 weist eine Mehrzahl in einer ersten Richtung (x-Richtung) nebeneinander angeordneter und voneinander beabstandeter Emitter 101, 102, 103 auf. Die von den einzelnen Emittern 101, 102, 103 des Laserdiodenbarrens 100 emittierten Laserstrahlen - nachfolgend als Teilstrahlen 10, 11, 12 bezeichnet - weisen in einer langen, der x-Richtung entsprechenden Achse eine deutlich kleinere Divergenz auf als in einer zweiten, der y-Richtung entsprechenden kurzen Achse. Es ist allgemein üblich, die Richtung größerer Divergenz (kurze Achse) als "Fast-Axis-Richtung" und die Richtung kleinerer Divergenz (lange Achse) als "Slow-Axis-Richtung" zu bezeichnen. Es ist bekannt, dass bei Laserdiodenbarren 100 der vorstehend genannten Art, bei denen mehrere Emitter 101, 102, 103 in einer Reihe nebeneinander angeordnet sind, eine so genannte "Smile"-Verzerrung auftreten kann. Diese "Smile"-Verzerrung rührt in erster Linie von einer Verbiegung des Laserdiodenbarrens 100 bei der Herstellung her.

In Strahlausbreitungsrichtung (z-Richtung) ist hinter dem Laserdiodenbarren 100 ein Fast-Axis-Kollimationsmittel 2 angeordnet, welches vorzugsweise als plankonvexe Zylinderlinse mit einer großen numerischen Apertur ausgebildet ist, wobei sich die Zylinderachse in der ersten Richtung (x-Richtung) erstreckt, in der die Emitter 101, 102, 103 des Laserdiodenbarrens 100 nebeneinander angeordnet sind. Insbesondere kann diese Zylinderlinse eine sehr kleine Brennweite aufweisen und vorzugsweise sehr nahe an den Emittern 101, 102, 103 des Laserdiodenbarrens 100 angeordnet sein.

In Strahlausbreitungsrichtung ist hinter dem Fast-Axis-Kollimationsmittel 2 ein optisches Strahltransformationsmittel 3 angeordnet, welches so ausgebildet ist, dass die Teilstrahlen 10, 11, 12, welche von den in x-Richtung nebeneinander angeordneten Emittern 101, 102, 103 des Laserdiodenbarrens 100 emittiert werden, gemeinsam um 90° gedreht werden können. Der grundlegende Aufbau des Strahltransformationsmittels 3 ist zum Beispiel aus der EP 1 006 382 A1 bekannt, so dass nachfolgend nur kurz auf das grundlegende Funktionsprinzip des Strahltransformationsmittels 3 eingegangen werden soll. Das Strahltransformationsmittel 3 ist aus einem transparenten Material hergestellt und umfasst sowohl auf einer Lichteintrittsseite 30, als auch auf einer Lichtaustrittsseite 31 optisch funktionale Grenzflächen, die jeweils mehrere Zylinderlinsensegmente 8, 8' aufweisen, deren Zylinderachsen im Wesentlichen parallel zueinander orientiert sind. Die Zylinderachsen aller Zylinderlinsensegmente 8, 8' schließen mit einer Basisseite des optischen Strahltransformationsmittels 3, die sich in x-Richtung erstreckt, einen Winkel von 45° ein. Dabei sind mehrere Zylinderlinsensegmente 8, 8' nebeneinander auf jeder der beiden x-y-Flächen des Strahltransformationsmittels 3 ausgebildet. Beim Durchgang durch das optische Strahltransformationsmittel 3 erfahren die Teilstrahlen 10, 11, 12, eine gemeinsame Drehung um 90°. Die "Smile"-Verzerrung wirkt sich in der Weise aus, dass ein Teil der Emitter 101, 102, 103 des Laserdiodenbarrens 100 nicht auf der Höhe der optischen Achse abstrahlen. Die optische Achse für jeden der Emitter 101, 102, 103 wird dabei durch den Scheitel des als Zylinderlinsenmittel ausgeführten Fast-Axis-Kollimationsmittels 2 definiert. Diejenigen Emitter 101, 102, 103 des Laserdiodenbarrens 100, deren Teilstrahlen 10, 11, 12 das Fast-Axis-Kollimationsmittel 2 in der "falschen" Höhe treffen, werden zwar gut kollimiert, das Poynting der kollimierten Teilstrahlen 10, 11, 12 dieser Emitter 101, 102, 103 hat aber einen Fehler gegenüber den übrigen, in der "richtigen" Höhe liegenden Emittern 101, 102, 103. Dieser Poyting-Fehler läst sich wie folgt abschätzen: Höhenfehler [µm] / Brennweite des Fast-Axis-Kollimationsmittels 2 [mm] = Poynting-Fehler [mrad]. Nach der Drehung der Teilstrahlen 10, 11, 12 durch das Strahltransformationsmittel 3 ist der Poynting-Fehler ebenfalls gedreht. Daraus folgt, dass die Einhüllende der Winkelverteilung aller Emitter 101, 102, 103 des Laserdiodenbarrens 100 entsprechend vergrößert (verbreitert) ist.

Um eine Kompensation der "Smile"-Verzerrung zu erreichen, weist die Beleuchtungsvorrichtung 1 in diesem Ausführungsbeispiel ein Prismenarray 4 mit einer Anzahl in der ersten Richtung (x-Richtung) nebeneinander angeordneter Prismenmittel 40, 40' auf, die jeweils eine Lichteintrittsfläche 400, 400' und eine Lichtaustrittsfläche 401, 401' umfassen. Das Prismenarray 4 ist in Strahlausbreitungsrichtung (z-Richtung) hinter dem optischen Strahltransformationsmittel 3 angeordnet. Jeder der Teilstrahlen 10, 11, 12 durchquert jeweils eines der Prismenmittel 40, 40', so dass jedem der Teilstrahlen 10, 11, 12 genau ein Prismenmittel 40, 40' des Prismen-Arrays 4 zugeordnet ist.

Zur Vereinfachung der Darstellung sind in Fig. 1 wie auch in den übrigen Figuren lediglich drei Teilstrahlen 10, 11, 12 eingezeichnet. Vorliegend soll angenommen werden, dass der mittlere Teilstrahl 12 auf Grund der "Smile"-Verzerrung der Emitter 101, 102, 103 des Laserdiodenbarrens 100 gegenüber den beiden übrigen Teilstrahlen 10, 11 einen Versatz von 3 µm in y-Richtung aufweist. Die beiden übrigen Emitter 101, 102 befinden sich auf der Höhe des Scheitels des Fast-Axis-Kollimationsmittels 2. Um diesen Versatz zu kompensieren, weist das diesem Teilstrahl 12 zugeordnete Prismenmittel 40' eine Keilform auf. Das bedeutet, dass dieses Prismenmittel 40' eine in der ersten Richtung (x-Richtung) betrachtet leicht angeschrägte Lichtaustrittsfläche 400' zum Parallelisieren des Teilstrahls 12 aufweist. Diejenigen Prismenmittel 40, die denjenigen Teilstrahlen 10, 11 zugeordnet sein, deren Emitter 101, 102 keinerlei Versatz aufweisen, weisen zueinander parallele Lichteintrittsflächen 400 und Lichtaustrittsflächen 401 und somit keine Keilform auf.

Der Poynting-Fehler hinter dem optischen Strahltransformationsmittel 3 kann durch das Prismenarray 4 ganz allgemein für jeden Emitter 101, 102, 103 durch entsprechend angepasste Keilformen der Prismenmittel 40, 40' korrigiert werden, wobei vorzugsweise die entsprechenden Anschrägungen nur im Bereich der Lichtaustrittsflächen 401, 401' vorgesehen sind.

Um in vorteilhafter Weise die Lücken zwischen den kollimierten Teilstrahlen 10, 11, 12 zu füllen und die Strahldivergenz zu verringern, kann in Strahlausbreitungsrichtung hinter dem Prismenarray 4 ein hier nicht explizit dargestelltes Strahlaufweitungsmittel angeordnet sein. Das Strahlaufweitungsmittel kann insbesondere ein Teleskoparray mit einer Mehrzahl in x-Richtung nebeneinander angeordneter Teleskopmittel sein, welche die Teilstrahlen 10, 11, 12 aufweiten können. Die Teleskopmittel können vorzugsweise als Galilei-Teleskopmittel mit einer konkav geformten Lichteintrittsseite und einer konvex geformten Lichtaustrittsseite ausgebildet sein.

Die Beleuchtungsvorrichtung 1 ermöglicht eine wirksame Kompensation der "Smile"-Verzerrung, so dass das Strahlparameterprodukt sehr nahe an die theoretisch mögliche Grenze gebracht werden kann.

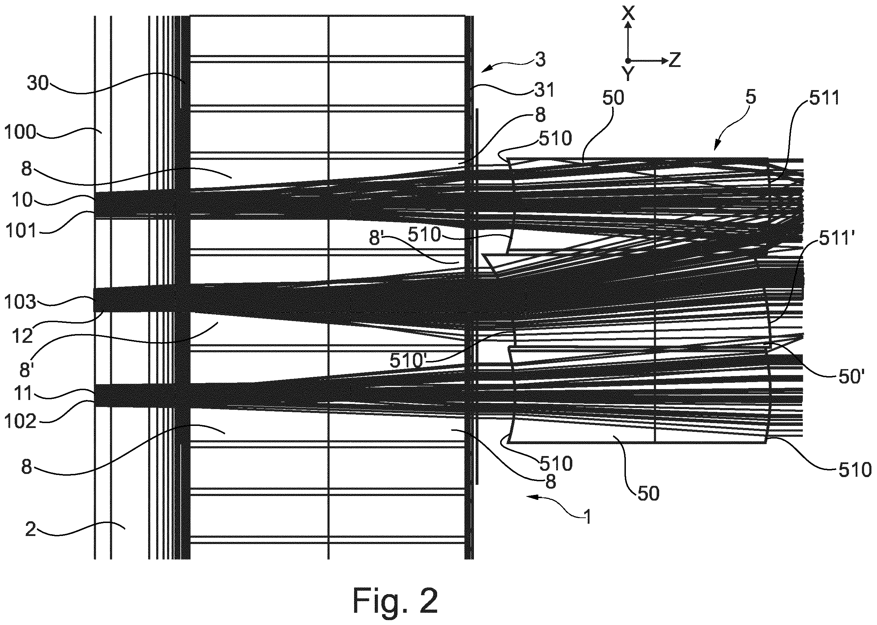

Unter Bezugnahme auf Fig. 2 soll nachfolgend ein zweites Ausführungsbeispiel einer Beleuchtungsvorrichtung 1 näher erläutert werden. Die Beleuchtungsvorrichtung 1 umfasst wiederum einen Laserdiodenbarren 100 mit einer Mehrzahl von Emittern 101, 102, 103, die in der ersten Richtung (x-Richtung) nebeneinander angeordnet sind, ein Fast-Axis-Kollimationsmittel 2, das in der oben unter Bezugnahme auf Fig. 1 beschriebenen Weise als plankonvexe Zylinderlinse mit einer sich in der ersten Richtung (x-Richtung) erstreckenden Zylinderachse ausgeführt ist, sowie ein Strahltransformationsmittel 3, das so ausgebildet ist, dass es die Teilstrahlen 10, 11, 12 in der oben erläuterten Weise gemeinsam um 90° drehen kann.

Zur Kompensation der "Smile"-Verzerrung weist die Beleuchtungsvorrichtung 1 in diesem Ausführungsbeispiel ein speziell ausgeführtes Teleskop-Array 5 mit einer Mehrzahl von Teleskopmitteln 50, 50' auf, die in der ersten Richtung (x-Richtung) nebeneinander angeordnet sind und die Teilstrahlen 10, 11, 12 nach dem Hindurchtritt aufweiten können. Die Anzahl der Teleskopmittel 50, 50' entspricht der Anzahl der Emitter 101, 102, 103 des Laserdiodenbarrens 100, so dass jedem der Teilstrahlen 10, 11, 12 genau ein Teleskopmittel 50, 50' zugeordnet ist. Jedes der Teleskopmittel 50, 50' umfasst jeweils eine konkav geformte Lichteintrittsfläche 510, 510' für einen der Teilstrahlen 10, 11, 12 sowie eine Lichtaustrittsfläche 511, 511', die konvex geformt ist. Die Kompensation der "Smile"-Verzerrung ist vorliegend als Funktion in das Teleskop-Array 5 integriert. Dies wird dadurch erreicht, dass zumindest einige der Teleskopmittel 50, 50' asymmetrisch in Bezug auf die optische Achse der ihnen zugeordneten Teilstrahlen 10, 11, 12 geformt sind oder einen seitlichen Versatz zu dieser optischen Achse aufweisen. Eine asymmetrische Formung der Lichteintrittsflächen 510, 510' der Teleskopmittel 50, 50' ist in diesem Zusammenhang besonders vorteilhaft, weil auf diese Weise verhindert werden kann, dass in eines der Teleskopmittel 50, 50' eingetretene Teilstrahlen 10, 11, 12 auf Grund der "Smile-Verzerrung" aus der Lichtaustrittsfläche 511, 511' eines anderen (insbesondere eines benachbarten) Teleskopmittels 50, 50' heraustreten.

In Fig. 2 befinden sich wiederum die beiden Emitter 101, 102 des Laserdiodenbarrens 100, die den ersten Teilstrahl 10 und den zweiten Teilstrahl 11 emittieren, auf der Höhe des Scheitels des als Zylinderlinse ausgebildeten Fast-Axis-Kollimationsmittels 2. Der zwischen diesen beiden Emittern 101, 102 angeordnete Emitter 103 des Laserdiodenbarrens 100, der den dritten Teilstrahl 12 emittiert, welcher durch das diesem zugeordnete Teleskopmittel 50' hindurchtritt, weist gegenüber den beiden anderen Emittern 101, 102 einen Höhenversatz (hier: 3 µm) auf. Aus Fig. 2 wird deutlich, dass diejenigen Teleskopmittel 50, durch die der erste Teilstrahl 10 und der zweite Teilstrahl 11 hindurchtreten, symmetrisch zur optischen Achse des betreffenden Teilstrahls 10, 11 ausgebildet sind. Das dem dritten Laserstrahlbündel 12 zugeordnete Teleskopmittel 50' ist auf seiner konkaven Lichteintrittsfläche 510' und auf seiner konvexen Lichtaustrittsfläche 511' so geformt, dass in diesen Bereichen eine Asymmetrie in Bezug auf die optische Achse des dritten Laserstrahlbündels 12 gegeben ist und dieses nach dem Hindurchtritt parallelisiert werden kann. Diese Asymmetrien können auf besonders einfache Weise dadurch erhalten werden, dass das ansonsten in Bezug auf die optische Achse des dritten Laserstrahlbündels 12 symmetrische Teleskopmittel 50' auf der Lichteintrittsfläche 510' und auf der Lichtaustrittsfläche 511' dezentriert ausgeschnitten wird, um die in Fig. 2 gezeigt Form zu erhalten. Grundsätzlich ist es möglich, dass die Lichteintrittsfläche 510' und die Lichtaustrittsfläche 511' in Bezug auf die optische Achse unterschiedlich dezentriert beziehungsweise asymmetrisch ausgebildet sind.

Auch diese Beleuchtungsvorrichtung 1 ermöglicht eine wirksame Kompensation der "Smile"-Verzerrung durch Parallelisieren derjenigen Teilstrahlen 12, deren Emitter 103 einen Höhenversatz aufweisen, so dass das Strahlparameterprodukt sehr nahe an die theoretisch mögliche Grenze gebracht werden kann.

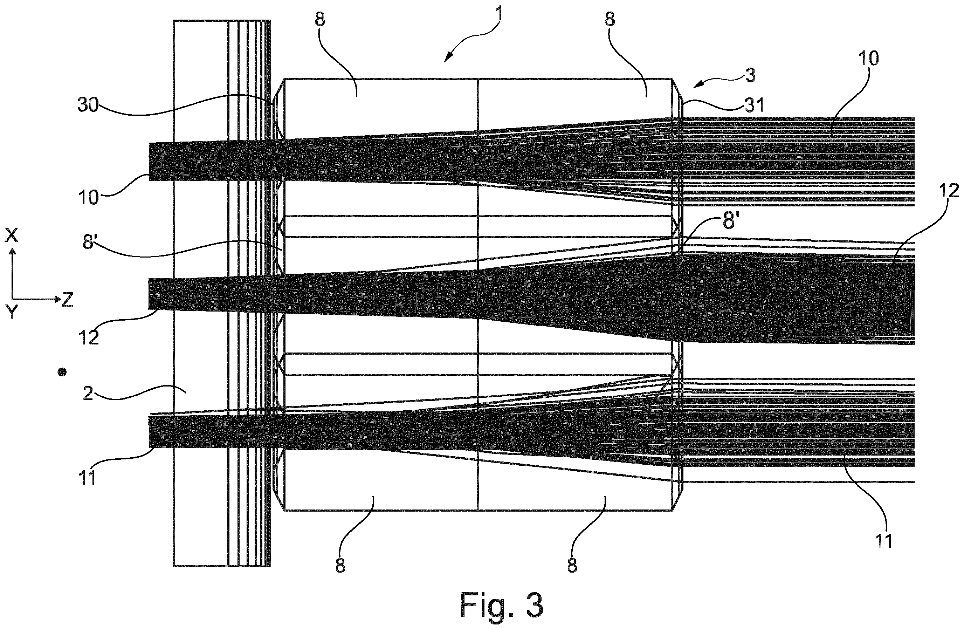

Unter Bezugnahme auf Fig. 3 soll nachfolgend eine Beleuchtungsvorrichtung 1 näher erläutert werden, die nicht Gegenstand der vorliegenden Erfindung ist. Die Beleuchtungsvorrichtung 1 umfasst wiederum einen (hier nicht explizit dargestellten) Laserdiodenbarren mit einer Mehrzahl von Emittern, die in x-Richtung nebeneinander angeordnet sind, ein Fast-Axis-Kollimationsmittel 2, das in der oben unter Bezugnahme auf Fig. 1 beschriebenen Weise als plankonvexe Zylinderlinse mit einer Zylinderachse in der ersten Richtung (x-Richtung) ausgeführt ist, sowie ein Strahltransformationsmittel 3, das die Teilstrahlen 10, 11, 12 in der oben beschriebenen Weise um 90° drehen kann. Bei der Beleuchtungsvorrichtung 1 gemäß Fig. 3 weist das optische Strahltransformationsmittel 3 sowohl auf der Lichteintrittsseite 30, als auch auf der Lichtaustrittsseite 31 speziell geformte Zylinderlinsensegmente 8, 8' auf, um die "Smile"-Verzerrung durch Parallelisieren der Teilstrahlen 10, 11, 12 zu kompensieren. Dies wird vorliegend dadurch erreicht, dass einige der Zylinderlinsensegmente 8, 8' des Strahltransformationsmittels 3 asymmetrisch in Bezug auf die optische Achse der ihnen zugeordneten Teilstrahlen 10, 11, 12 geformt sind oder einen seitlichen Versatz zur optischen Achse aufweisen und damit dezentriert sind.

In Fig. 3 befinden sich wiederum die beiden Emitter des Laserdiodenbarrens, die den ersten Teilstrahl 10 und den zweiten Teilstrahl 11 emittieren, auf der Höhe des Scheitels des als Zylinderlinse ausgebildeten Fast-Axis-Kollimationsmittels 2. Der zwischen diesen beiden Emittern angeordnete Emitter des Laserdiodenbarrens, der den dritten Teilstrahl 12 emittiert, welcher durch die diesem zugeordneten Zylinderlinsensegmente 8' hindurchtritt, weist gegenüber den beiden vorstehend genannten Emittern einen Höhenversatz (hier: 3 µm) auf. Diejenigen Zylinderlinsensegmente 8, durch die der erste Teilstrahl 10 und der zweite Teilstrahl 11 hindurchtreten, sind symmetrisch zur optischen Achse ausgebildet sind. Zumindest eines der dem dritten Teilstrahl 12 zugeordneten Zylinderlinsensegmente 8' auf der Lichteintrittsseite 30 oder der Lichtaustrittsseite 31 ist so geformt, dass es eine Asymmetrie in Bezug auf die optische Achse des dritten Teilstrahls 12 aufweist. Es besteht auch die Möglichkeit, dass die beiden, dem dritten Teilstrahl 12 zugeordneten Zylinderlinsensegmente 8' auf der Lichteintrittsseite 30 und der Lichtaustrittsseite 31 so geformt sind, dass diese eine Asymmetrie in Bezug auf die optische Achse des dritten Teilstrahls 12 aufweisen. Alternativ besteht auch die Möglichkeit, dass die dem dritten Teilstrahl 12 zugeordneten Zylinderlinsensegmente 8' auf der Lichteintrittsseite 30 und/oder der Lichtaustrittsseite 31 symmetrisch geformt sind, aber zur optischen Achse des Teilstrahls 12 seitlich versetzt sind.

Die "Smile"-Kompensation, die mit der Beleuchtungsvorrichtung 1 gemäß Fig. 3 erreicht werden kann, wirkt anders als im ersten und zweiten Ausführungsbeispiel der Erfindung in beiden Achsen, also in der Slow-Axis-Richtung und in der Fast-Axis-Richtung. Der Poynting-Fehler der dann zu der noch nicht kollimierten Achse hinzukommt, ist jedoch sehr klein verglichen mit der Divergenz dieser Achse. Nach einer Slow-Axis-Kollimation mit einem Slow-Axis-Kollimationsmittel ist der Strahldurchmesser nur geringfügig größer als vorher.

Nach der Kompensation der "Smile"-Verzerrung kann eine Zylinderlinse in allen Ausführungsbeispielen die Divergenz der Slow-Axis kollimieren. Der auf diese Weise kollimierte und symmetrisierte Laserstrahl kann mit zwei Zylinderlinsen oder einer sphärisch oder asphärisch ausgebildeten Linse in eine Faser eingekoppelt werden.

## Patentansprüche

1. Beleuchtungsvorrichtung (1), umfassend
- einen Laserdiodenbarren (100) mit einer Mehrzahl von Emittern (101, 102, 103), die in einer ersten Richtung nebeneinander angeordnet sind und während des Betriebs Teilstrahlen (10, 11, 12) emittieren, die in der ersten Richtung, die eine Slow-Axis-Richtung bildet, eine geringere Strahldivergenz aufweisen als in einer zu der ersten Richtung orthogonalen zweiten Richtung, welche eine Fast-Axis-Richtung bildet, wobei zumindest einige der Emitter (101, 102, 103) gegenüber den anderen Emittern (101, 102, 103) einen Höhenversatz aufweisen, so dass diese Emitter (101, 102, 103) die Teilstrahlen (10, 11, 12) nicht auf der Höhe einer optischen Achse des Laserdiodenbarrens (100) abstrahlen,
- ein Fast-Axis-Kollimationsmittel (2), das in einer zu der Slow-Axis-Richtung und zu der Fast-Axis-Richtung orthogonalen Strahlausbreitungsrichtung hinter dem mindestens einen Laserdiodenbarren (100) angeordnet ist,
- ein Strahltransformationsmittel (3), welches in Strahlausbreitungsrichtung hinter dem Fast-Axis-Kollimationsmittel (2) angeordnet ist und dazu eingerichtet ist, die Teilstrahlen (10, 11, 12) bei einem Hindurchtritt um 90° zu drehen,
**dadurch gekennzeichnet, dass** die Beleuchtungsvorrichtung (1) ein Prismenarray (4) umfasst, das in Strahlausbreitungsrichtung hinter dem Strahltransformationsmittel (3) angeordnet ist und eine der Anzahl der Emitter (101, 102, 103) entsprechende Anzahl von Prismenmitteln (40, 40') umfasst, die in der ersten Richtung nebeneinander angeordnet sind und jeweils eine Lichteintrittsfläche (400, 400') und eine Lichtaustrittsfläche (401, 401') für einen der Teilstrahlen (10, 11, 12) aufweisen, wobei die Lichteintrittsflächen (400') und/oder die Lichtaustrittsflächen (401') derjenigen Prismenmittel (40'), durch die diejenigen Teilstrahlen (12) hindurchtreten, die vor der Strahldrehung mittels des Strahltransformationsmittels (3) einen Höhenversatz aufweisen, so ausgebildet sind, dass ein Poynting-Fehler [mrad] = Höhenfehler [µm] / Brennweite [mm] des Fast-Axis-Kollimationsmittels (2) durch Parallelisieren dieser Teilstrahlen (12) korrigiert wird, wobei die Lichtaustrittsflächen (401') derjenigen Prismenmittel (40'), durch die diejenigen Teilstrahlen (12) hindurchtreten, die vor der Strahldrehung mittels des Strahltransformationsmittels (3) einen Höhenversatz aufweisen, in der ersten Richtung keilförmig ausgebildet sind, und wobei diejenigen Prismenmittel (40), durch die diejenigen Teilstrahlen (10, 11) hindurchtreten, die vor der Strahldrehung mittels des Strahltransformationsmittel (3) keinen Höhenversatz aufweisen, zueinander parallele Lichteintrittsflächen (400) und Lichtaustrittsflächen (401) aufweisen.

2. Beleuchtungsvorrichtung (1) nach Anspruch 1, **dadurch gekennzeichnet, dass** in Strahlausbreitungsrichtung hinter dem Prismenarray (4) mindestens ein Strahlaufweitungsmittel angeordnet ist.

3. Beleuchtungsvorrichtung (1) nach Anspruch 2, **dadurch gekennzeichnet, dass** das Strahlaufweitungsmittel ein Teleskoparray mit einer Mehrzahl von Teleskopmitteln umfasst, die in der ersten Richtung nebeneinander angeordnet sind.

4. Beleuchtungsvorrichtung (1), umfassend
- einen Laserdiodenbarren (100) mit einer Mehrzahl von Emittern (101, 102, 103), die in einer ersten Richtung nebeneinander angeordnet sind und während des Betriebs Teilstrahlen (10, 11, 12) emittieren, die in der ersten Richtung, die eine Slow-Axis-Richtung bildet, eine geringere Strahldivergenz aufweisen als in einer zu der ersten Richtung orthogonalen zweiten Richtung, welche eine Fast-Axis-Richtung bildet, wobei zumindest einige der Emitter (101, 102, 103) gegenüber den anderen Emittern (101, 102, 103) einen Höhenversatz aufweisen, so dass diese Emitter (101, 102, 103) die Teilstrahlen (10, 11, 12) nicht auf der Höhe einer optischen Achse des Laserdiodenbarrens (100) abstrahlen,
- ein Fast-Axis-Kollimationsmittel (2), das in einer zu der Slow-Axis-Richtung und zu der Fast-Axis-Richtung orthogonalen Strahlausbreitungsrichtung hinter dem mindestens einen Laserdiodenbarren (100) angeordnet ist
- ein Strahltransformationsmittel (3), welches in Strahlausbreitungsrichtung hinter dem Fast-Axis-Kollimationsmittel (2) angeordnet ist und dazu eingerichtet ist, die Teilstrahlen (10, 11, 12) bei einem Hindurchtritt um 90° zu drehen,
- ein Teleskoparray (5), das in Strahlausbreitungsrichtung hinter dem Strahltransformationsmittel (3) angeordnet ist und eine der Anzahl der Emitter (101, 102, 103) entsprechende Anzahl von Teleskopmitteln (50, 50') umfasst, die in der ersten Richtung nebeneinander angeordnet sind und jeweils eine Lichteintrittsfläche (500, 500') und eine Lichtaustrittsfläche (501, 501') für einen der Teilstrahlen (10, 11, 12) aufweisen, wobei die Lichteintrittsflächen (500, 500') und die Lichtaustrittsflächen (501, 501') so geformt sind, dass sie jeweils einen der Teilstrahlen (10, 11, 12) bei dem Hindurchtritt durch das Teleskopmittel (50, 50') aufweiten und durch die Teleskopmittel (50, 50') Lücken zwischen benachbarten Teilstrahlen (10, 11, 12) geschlossen werden,
**dadurch gekennzeichnet, dass** die Lichteintrittsflächen (500') und/oder die Lichtaustrittsflächen (501') derjenigen Teleskopmittel (50'), durch die diejenigen Teilstrahlen (12) hindurchtreten, die vor der Strahldrehung mittels des Strahltransformationsmittels (3) einen Höhenversatz aufweisen, so ausgebildet sind, dass ein Poynting-Fehler [mrad] = Höhenfehler [µm] / Brennweite [mm] des Fast-Axis-Kollimationsmittels (2) durch Parallelisieren dieser Teilstrahlen (12) korrigiert wird.

5. Beleuchtungsvorrichtung (1) nach Anspruch 4, **dadurch gekennzeichnet, dass** die Lichteintrittsflächen (500') und/oder die Lichtaustrittsflächen (501') derjenigen Teleskopmittel (50'), durch die diejenigen Teilstrahlen (12), die vor der Strahldrehung mittels des Strahltransformationsmittels (3) einen Höhenversatz aufweisen, hindurchtreten, asymmetrisch in Bezug auf die optische Achse der ihnen zugeordneten Teilstrahlen (12) geformt sind/ist.

6. Beleuchtungsvorrichtung (1) nach Anspruch 4, **dadurch gekennzeichnet, dass** diejenigen Teleskopmittel (50'), durch die diejenigen Teilstrahlen (12), die vor der Strahldrehung mittels des Strahltransformationsmittels (3) einen Höhenversatz aufweisen, hindurchtreten, einen seitlichen Versatz zur optischen Achse aufweisen.

7. Beleuchtungsvorrichtung (1) nach einem der Ansprüche 4 bis 6, **dadurch gekennzeichnet, dass** die Lichteintrittsflächen (500, 500') der Teleskopmittel (5) konkav geformt sind und dass die Lichtaustrittsflächen (501, 501') der Teleskopmittel (5) konvex geformt sind.

## Claims

1. A lighting device (1) comprising
- a laser-diode bar (100) with a plurality of emitters (101, 102, 103) which are arranged adjacently to one another in a first direction and emit sub-beams (10, 11, 12) during operation, said sub-beams having a lower beam divergence in a first direction that forms a slow-axis direction than in a second direction that forms a fast-axis direction and is perpendicular to the first direction, with at least some of the emitters (101, 102, 103) having a height offset in relation to the other emitters (101, 102, 103) so that these emitters (101, 102, 103) do not emit the sub-beams (10, 11, 12) at the height of an optical axis of the laser-diode bar (100),
- a fast-axis collimation means (2) positioned behind the at least one laser-diode bar (100) in a beam-propagation direction perpendicular to the slow-axis direction and to the fast-axis direction,
- a beam transformation means (3) positioned behind the fast-axis collimation means (2) in the beam-propagation direction and designed to rotate the sub-beams (10, 11, 12) through 90° as they pass through said means,
**characterised in that** the lighting device (1) comprises a prism array (4) positioned behind the beam transformation means (3) in the beam-propagation direction and comprises a number of prism means (40, 40') corresponding to the number of emitters (101, 102, 103), arranged adjacently to one another in the first direction, each of which has an incident light face (400, 400') and a light output face (401, 401') for one of the sub-beams (10, 11, 12),
wherein the incident light faces (400') and/or the light output faces (401') of those prism means (40') pass through by the sub-beams (12), which have a height offset before the beam rotation via the beam transformation means (3), being designed in such a way that a Poynting error [mrad] = height error [µm]/focal length [mm] of the fast-axis collimation means (2) is corrected by the parallelisation of such sub-beams (12), wherein the light output faces (401') of those prism means (40') pass through by the sub-beams (12), which have a height offset before the beam rotation via the beam transformation means (3), being formed in a wedge shape in the first direction and wherein those prism means (40) through which the sub-beams (10, 11), which do not have a height offset before the beam rotation via the beam transformation means (3), pass, have incident light faces (400) and light output faces (401) that are parallel to one another.

2. A lighting device (1) according to claim 1, **characterised in that** at least one beam separation means is positioned behind the prism array (4) in the beam-propagation direction.

3. A lighting device (1) according to claim 2, **characterised in that** the beam separation means comprises a telescope array with a plurality of telescope means which are positioned adjacent to one another in the first direction.

4. A lighting device (1) comprising
- a laser-diode bar (100) with a plurality of emitters (101, 102, 103) which are arranged adjacently to one another in a first direction and emit sub-beams (10, 11, 12) during operation, said sub-beams having a lower beam divergence in a first direction that forms a slow-axis direction than in a second direction that forms a fast-axis direction and is perpendicular to the first direction, wherein at least some of the emitters (101, 102, 103) have a height offset in relation to the other emitters (101, 102, 103) so that these emitters (101, 102, 103) do not emit the sub-beams (10, 11, 12) at the height of an optical axis of the laser-diode bar (100),
- a fast-axis collimation means (2) positioned behind the at least one laser-diode bar (100) in a beam-propagation direction perpendicular to the slow-axis direction and to the fast-axis direction,
- a beam transformation means (3) positioned behind the fast-axis collimation means (2) in the beam-propagation direction and designed to rotate the sub-beams (10, 11, 12) through 90° as they pass through said means,
- a telescope array (5) that is positioned behind the beam transformation means (3) in the beam-propagation direction and comprises a number of telescope means (50, 50') corresponding to the number of emitters (101, 102, 103) and arranged adjacently to one another in the first direction, each of which has an incident light face (500, 500') and a light output face (501, 501') for one of the sub-beams (10, 11, 12), wherein the incident light faces (500, 500') and the light output faces (501, 501') are formed in such a way that they each widen one of the sub-beams (10, 11, 12) when they pass through the telescope means (50, 50') and the telescope means (50, 50') closes gaps between adjacent sub-beams (10, 11, 12),
**characterised in that** the incident light faces (500') and/or the light output faces (501') of those telescope means (50'), passed through by the sub-beams (12), which have a height offset before the beam rotation via the beam transformation means (3), are designed in such a way that a Poynting error [mrad] = height error [µm]/focal length [mm] of the fast-axis collimation means (2) is corrected by the parallelisation of such sub-beams (12).

5. A lighting device (1) according to claim 4, **characterised in that** the incident light faces (500') and/or the light output faces (501') of the telescope means (50') passed through by the sub-beams (12), which have a height offset before the beam rotation via the beam transformation means (3), are/is asymmetrically formed in relation to the optical axis of the sub-beams (12) assigned to it.

6. A lighting device (1) according to claim 4, **characterised in that** the telescope means (50') passed through by the sub-beams (12), which have a height offset before the beam rotation via the beam transformation means (3), has a laterally offset from the optical axis.

7. A lighting device (1) according to one of claims 4 to 6, **characterised in that** the incident light faces (500, 500') of the telescope means (5) are concavely formed and the light output faces (501, 501') of the telescope means (5) are convexly formed.

## Revendications

1. Dispositif d'éclairage (1), comprenant
- une barre de diodes laser (100) comportant une pluralité d'émetteurs (101, 102, 103), qui sont agencés côte à côte dans une première direction et émettent des faisceaux partiels (10, 11, 12) pendant le fonctionnement, qui dans la première direction, formant une direction d'axe lent, présentent une divergence de faisceau inférieure à une seconde direction orthogonale par rapport à la première direction, laquelle forme une direction d'axe rapide, dans lequel au moins l'un des émetteurs (101, 102, 103) présente un décalage en hauteur par rapport aux autres émetteurs (101, 102, 103), de sorte que ces émetteurs (101, 102, 103) n'émettent pas les faisceaux partiels (10, 11, 12) à la hauteur d'un axe optique de la barre de diodes laser (100),
- un moyen de collimation d'axe rapide (2) qui est agencé derrière la au moins une barre de diodes laser (100) dans une direction de propagation de faisceau orthogonale à la direction d'axe lent et à la direction d'axe rapide,
- un moyen de transformation de faisceau (3), lequel est agencé derrière le moyen de collimation d'axe rapide (2) dans la direction de propagation de faisceau et est adapté pour faire tourner les faisceaux partiels (10, 11, 12) sur 90° via un passage,
**caractérisé en ce que** le dispositif d'éclairage (1) comprend un réseau prismatique (4), qui est agencé derrière le moyen de transformation de faisceau (3) dans la direction de propagation de faisceau et comprend un nombre de moyens prismatiques (40, 40') correspondant au nombre d'émetteurs (101, 102, 103),qui sont agencés côte à côte dans la première direction et présentent chacun une surface d'entrée de lumière (400, 400') et une surface de sortie de lumière (401, 401') pour l'un des faisceaux partiels (10, 11, 12),
dans lequel les surfaces d'entrée de lumière (400') et/ou les surfaces de sortie de lumière (401') de ces moyens prismatiques (40') à travers lesquels passent les faisceaux partiels (12), qui présentent un décalage en hauteur avant la rotation de faisceau par l'intermédiaire du moyen de transformation de faisceau (3), sont conçues de manière à ce qu'un défaut de Poynting = défaut de hauteur [µm]/longueur focale [mm] du moyen de collimation d'axe rapide (2) est corrigé en parallélisant ces faisceaux partiels (12), dans lequel les surfaces de sortie de lumière (401') de ces moyens prismatiques (40') à travers lesquels passent ces faisceaux partiels (12), qui présentent un décalage en hauteur avant la rotation de faisceau par l'intermédiaire du moyen de transformation de faisceau (3), sont conçues en forme de coin dans la première direction, et dans lequel ces moyens prismatiques (40), à travers lesquels passent ces faisceaux partiels (10, 11), qui ne présentent pas de décalage en hauteur avant la rotation de faisceau par l'intermédiaire du moyen de transformation de faisceau (3), présentent des surfaces d'entrée de lumière (400) et des surfaces de sortie de lumière (401) parallèles entre elles.

2. Dispositif d'éclairage (1) selon la revendication 1, **caractérisé en ce qu'**au moins un moyen d'élargissement de faisceau est disposé dans la direction de propagation de faisceau derrière le réseau prismatique (4).

3. Dispositif d'éclairage (1) selon la revendication 2, **caractérisé en ce que** le moyen d'élargissement de faisceau comprend un réseau télescopique comportant une pluralité de moyens télescopiques, qui sont agencés côte à côte dans la première direction.

4. Dispositif d'éclairage (1), comprenant
- une barre de diodes laser (100) comportant une pluralité d'émetteurs (101, 102, 103), qui sont agencés côte à côte dans une première direction et émettent des faisceaux partiels (10, 11, 12) pendant le fonctionnement, qui dans la première direction, qui forme une direction d'axe lent, présentent une divergence de faisceau inférieure à une seconde direction orthogonale par rapport à la première direction, laquelle forme une direction d'axe rapide, dans lequel au moins l'un des émetteurs (101, 102, 103) présente un décalage en hauteur par rapport aux autres émetteurs (101, 102, 103), de sorte que ces émetteurs (101, 102, 103) n'émettent pas les faisceaux partiels (10, 11, 12) à la hauteur d'un axe optique de la barre de diodes laser (100),
- un moyen de collimation d'axe rapide (2), qui est agencé derrière la au moins une barre de diodes laser (100) dans une direction de propagation de faisceau orthogonale à la direction d'axe lent et à la direction d'axe rapide,
- un moyen de transformation de faisceau (3), lequel est agencé derrière le moyen de collimation d'axe rapide (2) dans la direction de propagation de faisceau et est adapté pour faire tourner les faisceaux partiels (10, 11, 12) sur 90° via un passage,
- un réseau télescopique (5), qui est agencé derrière les moyens de transformation de faisceau (3) dans la direction de propagation de faisceau et comprend un nombre de moyens télescopiques (50, 50') correspondant au nombre d'émetteurs (101, 102, 103) qui sont agencés côte à côte dans la première direction et présentent chacun une surface d'entrée de lumière (500, 500') et une surface de sortie de lumière (501, 501') pour l'un des faisceaux partiels (10, 11, 12), dans lequel les surfaces d'entrée de lumière (500, 500') et les surfaces de sortie de lumière (501, 501') sont formées de telle sorte qu'elles élargissent l'un des faisceaux partiels (10, 11, 12) via le passage par les moyens télescopiques (50, 50') et qu'un interstice entre les faisceaux partiels adjacents (10, 11, 12) est fermé via les moyens télescopiques (50, 50'),
**caractérisé en ce que** les surfaces d'entrée de lumière (500') et/ou les surfaces de sortie de lumière (501') de ces moyens télescopiques (50'), à travers lesquels passent ces faisceaux partiels (12), qui présentent un décalage en hauteur avant la rotation de faisceau par l'intermédiaire des moyens de transformation de faisceau (3), sont conçues de manière à ce qu'un défaut de Poynting [mrad] = défaut de hauteur [µm]/longueur focale [mm] du moyen de collimation d'axe rapide (2) est corrigé en parallélisant ces faisceaux partiels (12).

5. Dispositif d'éclairage (1) selon la revendication 4, **caractérisé en ce que** les surfaces d'entrée de lumière (500') et/ou les surfaces de sortie de lumière (501') de ces moyens télescopiques (50'), à travers lesquels passent ces faisceaux partiels (12), qui présentent un décalage en hauteur avant la rotation du faisceau par l'intermédiaire des moyens de transformation de faisceau (3), est/sont asymétrique(s) par rapport à l'axe optique de leurs faisceaux partiels associés (12).

6. Dispositif d'éclairage (1) selon la revendication 4, **caractérisé en ce que** ces moyens télescopiques (50'), à travers lesquels passent ces faisceaux partiels (12), qui présentent un décalage en hauteur avant la rotation de faisceau par l'intermédiaire des moyens de transformation de faisceau (3), présentent un décalage latéral par rapport à l'axe optique.

7. Dispositif d'éclairage (1) selon l'une des revendications 4 à 6, **caractérisé en ce que** les surfaces d'entrée de lumière (500, 500') des moyens télescopiques (5) sont de forme concave et **en ce que** les surfaces de sortie de lumière (501, 501') des moyens télescopiques (5) sont de forme convexe.
